Europäisches Patentamt

European Patent Office

Office européen des brevets

(19)

(11) Veröffentlichungsnummer: **0 341 465**
**A1**

(12) # EUROPÄISCHE PATENTANMELDUNG

(21) Anmeldenummer: **89107191.2**

(22) Anmeldetag: **21.04.89**

(51) Int. Cl.⁴: **C23C 18/18 , C25D 5/56**

(30) Priorität: **10.05.88 DE 3816494**

(43) Veröffentlichungstag der Anmeldung:
**15.11.89 Patentblatt 89/46**

(84) Benannte Vertragsstaaten:
**BE CH DE ES FR GB IT LI LU NL SE**

(71) Anmelder: **SCHERING AKTIENGESELLSCHAFT**
**Berlin und Bergkamen**
**Müllerstrasse 170/178 Postfach 65 03 11**
**D-1000 Berlin 65(DE)**

(72) Erfinder: **Bressel, Burkhard, Dr.**
**Kuno-Fischer-Strasse 13**
**D-1000 Berlin 19(DE)**
Erfinder: **Grapentin, Hans-Joachim**
**Wundtstrasse 17**
**D-1000 Berlin 19(DE)**
Erfinder: **Tessmann, Detlef**
**Alt-Heilgensee 38 G**
**D-1000 Berlin 27(DE)**

(54) **Lösung und Verfahren zum Ätzen und Aktivieren von isolierenden Oberflächen.**

(57) Die Erfindung betrifft eine Lösung zum Ätzen und Aktivieren von isolierenden Oberflächen zum Zwecke der nachfolgenden chemischen und gegebenenfalls galvanischen Abscheidung von Metallüberzügen, dadurch gekennzeichnet, daß die Lösung einen Aktivator und ein Ätzmittel enthält, sowie ein Verfahren zur Metallisierung isolierender Oberflächen.

EP 0 341 465 A1

EP 0 341 465 A1

## LÖSUNG UND VERFAHREN ZUM ÄTZEN UND AKTIVIEREN VON ISOLIERENDEN OBERFLÄCHEN

Die Erfindung betrifft eine Lösung zum Ätzen und Aktivieren von isolierenden Oberflächen zum Zwecke der nachfolgenden chemischen und gegebenenfalls galvanischen Abscheidung von Metallüberzügen sowie ein Verfahren zur Metallisierung isolierender Oberflächen.

Es ist bereits bekannt, die Oberfläche zum Zwecke der nachfolgenden chemischen und gegebenenfalls galvanischen Metallabscheidung vorzubehandeln, wofür an sich bekannte Ätzmittel und Aktivatoren in geeigneter Form verwendet werden. Diese Mittel werden in der Regel in getrennten Verfahrensschritten eingesetzt, was zeitraubend und aufwendig ist.

Ein Nachteil der chemischen Verfahren besteht darin, daß vielstufige, lange Prozeßfolgen benötigt werden, da die einzelnen chemischen Prozeßstufen nur sehr spezielle Aufgaben im Hinblick auf das zu erreichende Ziel darstellen. In der Regel ist zunächst ein Reinigungsschritt erforderlich, der lose anhaftende Verunreinigungen entfernt. Anschließend wird das zu metallisierende Objekt in den meisten Fällen chemisch aufgeschlossen, um einerseits eine die Haftung vermittelnde vergrößerte Oberfläche herzustellen und andererseits zu demselben Zweck eine hydrophile Oberfläche zu präparieren, damit die anschließende Adsorption von Molekülen und Ionen aus wässrigen Lösungen bevorzugt abläuft. Wird auf den ersten Reinigungsschritt verzichtet, so findet eine Reinigung der Substratoberfläche durch das Ätzmittel statt. Daran anschließend werden adsorptionsfördernde Substanzen an die Oberfläche gebracht, um eine Verankerung des Katalysatormediums und des darauf aufbauenden Metallfilms zu gewährleisten. Ätzprozesse sorgen für eine einwandfreie Reinigung von exponierten Metalloberflächen, so daß ein nahtloser Übergang zu den aufgebrachten Metallfilmen hergestellt wird.

Erst im Anschluß daran erfolgt der für die autokatalytische Metallabscheidung erforderliche katalytische Schritt unter Verwendung von Edelmetallkeimen. Für die kommerzielle Anwendung sind in dem vergangenen Jahren zwei prinzipielle Typen von Katalysatoren mit verschiedenen Abwandlungen entwickelt worden. Bei dem ersten Verfahren handelt es sich um Systeme aus Edelmetallkolloiden, die in verschiedener Weise mit Schutzkolloiden stabilisiert auf die präparierte Oberfläche aufziehen und als Startzentren für die Metallabscheidung aus autokatalytisch wirkenden Bädern dienen. Das andere System arbeitet mit Edelmetallkomplexen, die auf die präparierte Oberfläche aufziehen und in einem zweiten Schritt zu den katalytisch wirksamen Edelmetallkeimen reduziert werden.

Die gesamte beschriebene Vorbehandlungssequenz ist aufwendig, so daß erhebliche Investitionen für entsprechende Behandlungsmodule bereitgestellt werden müssen. Darüberhinaus müssen die verwendeten Chemikalien nachgeführt, überwacht und schließlich entsorgt werden. Dies erfordert weitere Kosten. Die Prozeßüberwachung in derartig umfangreichen Behandlungssequenzen birgt die Gefahr von Fehlfunktionen.

Aus den aufgeführten Nachteilen ergibt sich die Notwendigkeit des Einsatzes verkürzter Arbeitsabläufe.

Der Erfindung liegt die Aufgabe zugrunde, die Vorbehandlung von isolierenden Oberflächen zum Zwecke der nachfolgenden Metallisierung zu vereinfachen und insbesondere die Stufenzahl der Prozeßfolgen zu erniedrigen.

Diese Aufgabe wird erfindungsgemäß durch eine Lösung gemäß dem kennzeichnenden Teil des Patentanspruchs gelöst.

Weitere Ausgestaltungen der Erfindung sind den Kennzeichnungsteilen der Unteransprüche zu entnehmen.

Gegenstand der Erfindung ist weiterhin ein Verfahren zur Metallisierung isolierender Oberflächen.

Das erfindungsgemäße Verfahren kombiniert in vorteilhafter Weise den katalysierenden Schritt mit dem für eine optimale Metallhaftung erforderlichen Aufschlußschritt. Darüber hinaus kann die die adsorptionsfördenden Substanzen enthaltende Konditionierungssequenz entfallen, da eine ausreichende Fixierung der Edelmetallkeime auf der zu metallisierenden Oberfläche durch die gleichzeitige Hydrophilisierung durch das Aufschlußmedium erfolgt.

Der sich daraus ergebende Arbeitsablauf beinhaltet damit die folgenden Prozeßstufen:
1. Ätzaktivierung
2. Reduktion
3. Autokatalytische Metallisierung

Der Stufe 1 kann gegebenenfalls eine Vorreinigung und/oder Konditionierung vorangehen. Nach erfolgter erfindungsgemäßer Ätzaktivierung kann - falls erforderlich - eine Entfernung der Behandlungslösung angeschlossen werden.

Diese je nach technischen Erfordernissen drei- bis sechsstufige Sequenz ist damit wesentlich kürzer als die konventionelle Sequenz, die in der Regel mindestens zehn Schritte umfaßt.

2

Eine weitere erfindungsgemäße Behandlungssequenz geht davon aus, daß die Aktivierung mit dem dem Aufschlußschritt nachfolgenden Behandlungsbad zur Entfernung des Ätzmediums kombiniert wird.

Auch in diesem Fall ist eine außerordentlich kurze Behandlungssequenz verwirklicht. Die Prozeßstufen sind hierbei wie folgt:

1. Ätzaufschluß
2. Entfernung des Ätzmitels beziehungsweise von Ätzrückständen bei gleichzeitiger Aktivierung.
3. Reduktion
4. Autokatalytische Metallisierung

Erfindungsgemäß werden bei dem erstgenannten Arbeitsablauf zu dem die Oberfläche aufschließenden Ätzmittel Salze der ersten oder achten Nebengruppe des Periodensystems oder Mischungen dieser Salze zugegeben. Es ist auch möglich, komplexe Verbindungen dieser Elemente einzusetzen. Bei der anderen Behandlungssequenz werden die erwähnten Metallverbindungen in die der Ätzlösung nachfolgende Behandlungsstufe zur Entfernung zurückbleibender Reste des Ätzmittels auf der Substratoberfläche zugegeben.

Es können hierbei einfache anorganische oder organische Salze eingesetzt werden wie Fluoride, Chloride, Perchlorate, Bromide, Bromate, Jodide, Sulfate, Nitrite, Nitrate, Phosphate, Borate, Carbonate, Cyanide und andere anorganische Salze, Acetate, Formiate und höhere Homologe, Sulfamide, Sulfonate, Phosphonate und andere Salze organischer Säuren. Darüber hinaus können anorganische und organische Komplexverbindungen eingesetzt werden wie Fluoro-, Chloro-, Bromo-, Jodo-, Nitro-, Nitroso-, Hydroxo-, Cyano-, Amminverbindungen und andere anorganische Komplexsalze und organische Komplexe mit sauerstoffhaltigen Liganden wie Carbonsäuren, stickstoffhaltigen Liganden wie Amine, Amidine, Imidine, Imidazole,Pyrrole, Pyridine, Pyrimidine, Chinoline, Chinoxaline, Indole, Pyrazole, Pyrazoline, Pyrazolone, und andere und mit schwefelhaltigen Liganden wie Thiole, Disulfide, Thiazole unter anderem verwendet werden. Ebenso sind Komplexverbindungen mit ungesättigten Systemen vorteilhaft einsetzbar. Sebstverständlich sind ebenso Mischungen dieser Liganden beziehungsweise Anionen untereinander in einer Metallverbindung und Mischungen verschiedener Metallverbindungen untereinander verwendbar.

Eine weitere Ausgestaltung des erfindungsgemäßen Verfahrens ergibt sich unter zusätzlicher Verwendung von solchen Metallverbindungen, die stabile Oxide bilden und im keimbildenden Reduktionsschritt nicht zum Metall reduziert werden. Hierfür kommen Verbindungen des Zinks, Zinns, Titans, Aluminiums, Zirkoniums, Mangans, Molybdäns, Wolframs unter anderem in Betracht.

Der Einsatz derartiger Zusätze zu den Aktivatoren fördert die Adsorption der Aktivatorverbindung und bewirkt so eine verbesserte Belegungsdichte mit Katalysatorkeimen, so daß ein dichterer Metallüberzug mit verbesserter Haftung, insbesondere auf anorganischen Füllstoffen im Substratmaterial, zum Beispiel Glasfasern unter anderem mineralischen Partikeln, entsteht.

Die Aktivatoren wirken je nach Ätzmedium in unterschiedlicher Weise: Ein bevorzugt angewandtes Ätzmittel sind Permanganatsalze, die in vorteilhafter Ausführung in alkalischen Lösungen eingesetzt werden. Typische Zusammensetzungen dieses Ätzmediums enthalten 50 - 70 g/l $KMnO_4$, 40 - 100 g/l NaOH, 10 - 20 g/l $K_2MnO_4$ und zusätzliche Stabilisatoren, Netzmittel (fluoriert) und Regeneratoren, sofern nicht mit einer elektrolytischen Regeneration des verbrauchten Permanganat gearbeitet wird. Alternativ können zum Beispiel auch $NaMnO_4$, oder andere Salze des Permanganations eingesetzt werden. Vorteil dieser Verbindungen ist die bessere Löslichkeit, die in Verbindung mit Alkali zu einem stärkeren Ätzangriff führt.

Die in dieser Lösung eingebrachten aktivierenden Metallverbindugen und haftvermittelnden Metallverbindungen im oben beschriebenen Sinne liegen vermutlich je nach Art des eingesetzten Metalls als Hydroxokomplexe gelöst als Metalloxid/hydroxid-Sol oder als deren Mischung mit anorganischen Liganden vor. Während des Ätzangriffes auf das Basissubstrat wird aus der alkalischen $KMnO_4$-Lösung ein festhaftender Mangandioxidfilm auf der Substratoberfläche gebildet, in den die Aktivatorverbindung eingeschlossen wird.

Der gebildete Mangandioxidfilm wird von der Oberfläche nicht wieder entfernt und gelangt nach der eventuell durchgeführten Ätzreinigung exponierter Metalloberflächen in den Reduktor, wo die eingelagerten Verbindungen der ersten und achten Nebengruppe zu Metallkeimen, die katalysierend wirken, reduziert werden.

Saure reduzierende Lösungen sind an dieser Stelle zu vermeiden, um den numehr Edelmetall-aktivierten, katalytisch wirksamen Mangandioxidfilm nicht abzulösen. Vorteilhaft sind alkalische Reduktoren, die zum Beispiel Bor-Wasserstoffverbindungen wie $NaBH_4$, Dialkaylaminborane unter anderem enthalten.

Ein weiteres Ätzmittel sind Cr(VI)-Ionen, wie zum Beispiel in folgender Zusammensetzung:

1. 400 g/l $CrO_3$/400 g/l $H_2SO_4$
2. 900 g/l $CrO_3$

3. 40 g/l $CrO_3$/1000 g/l $H_2SO_4$

Diese Lösungen können zum verbesserten Angriff fluorierte Netzmittel enthalten. Ebenso wie bei Verwendung von Permanganat enthaltenden Lösungen werden in die Cr(VI)-ionen enthaltenden Ätzlösungen aktivierende Metallverbindungen der ersten oder achten Nebengruppe oder Mischungen dieser Verbindungen und in vorteilhafter Weise auch haftvermittelnde Metallverbindungen im oben beschriebenen Sinne eingebracht. Die aktivierenden Metallverbindungen liegen gelöst in hohen Oxidationsstufen vor. Während des hydrophilisierend wirkenden Ätzangriffes werden diese Verbindungen auf der Substratoberfläche adsorbiert.

Um den Ätzangriff zu intensivieren, kann zu Beginn des Arbeitsablaufes ein Konditionierungsschritt, zum Beispiel mit einem organischen Lösungsmittel, das das Substrat auch anquellen kann, vorgenommen werden.

Im Anschluß an den Ätzangriff werden die auf der Oberfläche verbleibenden Cr(VI)-Ionen durch Reduktion entfernt. Die hierfür verwendeten Reduktionsmittel und Zusammensetzungen der Reduktionslösungen sind hinlänglich bekannt (zum Beispiel Verwendung von Bisulfitlösungen).

Nach der eventuell vorgenommenen Ätzreinigung exponierter Metalloberflächen werden die Metallkeime durch Reduktion aus den aktivierenden, auf der Substratoberfläche adsorbierten Metallverbindungen gebildet. Es können hierfür dieselben Reduktionsmittel und Formulierungen verwendet werden wie oben bereits beschrieben.

Eine weitere bevorzugte Abwandlung des erfindungsgemäßen Verfahrens besteht im Fortfall des auf den Cr(VI)-Angriff folgenden Reduktionsschrittes zur Entfernung zurückgebliebener Cr(VI)-Reste auf der Oberfläche. In diesem Fall kann das zu metallisierende Objekt direkt aus der Ätzlösung über die eventuell durchzuführende Ätzreinigung exponierter Metalloberflächen in die Reduktionslösung überführt werden. Dieser erfüllt dann einerseits die Funktion der Bildung der katalysierenden Metallkeime durch Reduktion, andererseits aber auch die Funktion der Entfernung auf der Oberfläche zurückgebliebener Cr(VI).-Reste.

Eine der erfindungsgemäßen Behandlungssequenzen macht von der Möglichkeit Gebrauch, die Aktivatoren oder deren Mischungen in der der Ätzlösung nachfolgenden Behandlungsstufe einzusetzen, die die Aufgabe hat, Rückstände des Ätzmittels von der Oberfläche zu entfernen. Die hierfür geeigneten Reduktionsmittel sind hinlänglich bekannt. Es kommen auch hier die oben beschriebenen Metallverbindungen der ersten und achten Nebengruppe zur Anwendung.

Auch in diesem Fall ist die Verwendung haftvermittelnder Metallsalze in oben beschriebener Weise vorteilhaft. Bevorzugte Ätzmedien sind Oxidationsmittel wie Permanganat enthaltende Lösungen und Cr(VI)-Ionen enthaltende Lösungen, die in oben beschriebener Weise zusammengesetzt werden können.

Im Anschluß an die eventuell vorzunehmende Ätzreinigung exponierter Metalloberflächen erfolgt die Bildung der katalytisch wirkenden Edelmetallkeime durch Reduktion und danach die autokatalytische Metallabscheidung.

Die autokatalytische Metallisierung erfolgt in allen Fällen mit bekannten Metallisierungsbädern. Es können Kupfer-, Nickel-, Palladium-, Gold- oder andere außenstromlose Bäder eingesetzt werden.

Als Materialien mit isolierendeen Oberflächen lassen sich zum Beispiel folgende Kunststoffe erkennen: Duroplastische Kunststoffe, wie Epoxidharze, Polyimid, Melaminformaldehyd, Phenolformaldehyd, Harnstoff-Formaldehyd sowie thermoplastische Harze, wie Polycarbonat, Polyvinylchlorid, Polyetherimid und -sulfon, Polysulfon, Polyetherketon, Polymethacrylate, Polyethylen und -propyken, Polyamid, Polystyrol, Polyvinylacetat und andere.

Außerdem können auch Derivate, Copolymere und Mischungen der oben erwähnten Polymere und Verbundmaterialien erfindungsgemäß bearbeitet werden. Weiterhin sind ungefüllte sowie gefüllte Materialien, wie zum Beispiel mit Glasfasergewebe, einsetzbar. Die Materialien können als Formkörper, Granulate, mit innen-oder außenliegenden Metallfolien beschichtet, verwendet werden.

Ein bevorzugtes Einsatzgebiet ist die Herstellung von Leiterplatten für die Elektronikanwendung. In diesem Fall wird vorzugsweise von gebohrten und mit Kupferfolie kaschierten Epoxidharzplatten mit Glasfasergewebe ausgegangen, die zusätzliche Kunpferinnenlagen tragen können zur Herstellung von Mehrlagenschal tungen. Ziel der Metallisierung ist es vor allen Dingen, eine metallische Belegung der Bohrwand zu erreichen. Selbstverständlich können hierfür auch außen kaschierte Platten oder dreidimensionale Formkörper zum Einsatz kommen.

Die folgenden Beispiele dienen zur Erläuterung der Erfindung:

4

## BEISPIEL 1

Ein Epoxidharz/Glasfasergewebe-Laminat mit Epoxidharz-Außenflächen wird der folgenden Behandlungssequenz unterworfen:

| | |
|---|---|
| 1. Konditionieren: N-Methylpyrrolidon | 5 min, 40° C |
| 2. Ätzaktivieren: | 15 min, 70° C |
| 0,5 g / l AgNO₃ | |
| 60 g / l KMnO₄ | |
| 15 g / l K₂MnO₄ | |
| 30 g / l NaOH | |
| 0,5 g / l eines fluorierten Netzmittels | |
| 3. Reduzieren: | 5 min, RT |
| 1 g / l NaBH₄, 1 g / l NaOH | |
| 4. Autokatalytisch Verkupfern in einem handelsüblichen Dünnkupferbad | 15 min, 28° C |

Zwischen den einzelnen Stufen wird gespült. Man erhält einen dunklen, sehr dünnen Kupferniederschlag auf der gesamten Fläche.

## BEISPIEL 2

Wie Beispiel 1, unter Zusatz von 0,5 g/l Pd (NO₃)₂ anstatt AgNO₃ : Man erhält einen dickeren fleckigen Niederschlag.

## BEISPIEL 3

Die Metallisierung einer gebohrten und kupferkaschierten Leiterplatte aus einem Epoxidharz/Glasfasergewebe-Material mit den in Beispiel 2 angegebenen Versuchsbedingungen ergibt eine gute Belegung von Kupfer auf der Bohrlochinnenwand. Die Metalliserung auf der Kupferkaschierung ist gleichmäßig lachsfarben und haftfest.

In diesem Fall wurde eine zusätzliche Ätzreinigunsstufe mit einem handelsüblichen Ätzreiniger auf Na₂S₂O₈-Basis zwischen die Schritte 2. und 3. eingefügt, um die Kupferkaschierung von Oxidbelegungen zu befreien.

## BEISPIEL 4

Wie Beispiel 1 unter Zusatz von 0,5 g/l ZnO zur Ätzaktivierungslösung. Der abgeschiedene Niederschlag ist ganzflächig gleichmäßig lachsfarben. An einigen Stellen treten kleinere Blasen auf.

## BEISPIEL 5

Wie Beispiel 1 unter Zusatz von 0,5 g/l SnSO₄ zur Ätzaktivierlösung:
Man erhält einen glanzflächig haftfesten, gleichmäßigen Kupferniederschlag von lachsroter Farbe.

## BEISPIEL 6

Wie Beispiel 2 unter Zusatz von 0,5 g/l Na[Ag(CN)₂] anstatt AgNO₃:
Der abgeschiedene Kupferniederschlag ist wesentlich dicker als der aus Beispiel 1 abgeschiedene. Er ist ganzflächig haftfest und von lachsroter Farbe.

## BEISPIEL 7

Die Metallisierung einer kupferkaschierten und gebohrten Leiterplatte aus einem Epoxid-Harz/Glasfasergewebe-Material erfolgt nach folgender Vorbehandlung:

| | |
|---|---|
| 1. Ätzaktivieren:<br>1 g / l $AgNO_3$<br>900 g / l $CrO_3$ mit 5 g / l $Cr^{3+}$ | 2 min, 70° C |
| 2. Ätzreinigen<br>$Na_2S_2O_8$, $H_2SO_4$ | 1 min, 30° C |
| 3. Reduzieren:<br>1 g / l $NaBH_4$, 1 g / l NaOH | 10 min, 30° C |
| 4. Autokatalytisch Verkupfern in einem handeslüblichen Dünnkupferbad. | 15 min, 28° C |

Zwischen den einzelnen Stufen und insbesondere zwischen den Stufen 3. und 4. wird gut gespült.

Man erhält eine recht gute Belegung der Bohrlochinnenwand mit Kupfer. Die Kupferkaschierung ist gleichmäßig mit einem haftfesten, lachsrotfarbenen Kupferniederschlag überzogen.

BEISPIEL 8

Wie Beispiel 7, jedoch unter Zusatz von 0,5 g / l $SnSO_4$ zur Ätzaktivierung:

Die Belegung der Bohrlochinnenwand ist vollständig, auch die exponierten Glasfaserspritzen sind verkupfert. Für die Kupferkaschierung gilt das für Beispiel 7 erwähnte.

BEISPIEL 9

In einem weiteren Versuch wurde folgender Arbeitsablauf gewählt:

| | |
|---|---|
| 1. Ätzen:<br>900 g/l $CrO_3$ mit 5 g / l $Cr^{3+}$ | 2 min, 70° C |
| 2. Reduzieren (1. Stufe) ($H_2SO_4$-haltig) enthält 0,5 g/l Pd $(NO_3)_2$ | 5 min, 50° C |
| 3. Reduzieren (2.Stufe) | 5 min, RT |
| 4. Autokatalytisch verkupfern in einem handelsüblichen Dünnkupferbad | 15 min, 28° C |

Zwischen den eizelnen Stufen wird gut gespült. Ein Epoxidharz/Glasfaser-Laminat wurde in der vorstehenden Weise behandelt.

Man erhält einen roten bis lachsroten ganzflächigen Kupferniederschlag, der äußerst fest auf dem Grundmaterial haftet.

**Ansprüche**

1. Lösung zum Ätzen und Aktivieren von isolierenden Oberflächen zum Zwecke der nachfolgenden chemischen und gegebenenfalls galvanischen Abscheidung von Metallüberzügen, dadurch gekennzeichnet, daß die Lösung einen Aktivator und ein Ätzmittel enthält.

2. Lösung gemäß Anspruch 1, dadurch gekennzeichnet, daß diese als Aktivator eine oder meherere Verbindungen der Elemente der ersten oder achten Nebengruppe des Periodischen Systems der Elemente enthält.

3. Lösung gemäß Anspruch 2, dadurch gekennzeichnet, daß die Verbindungen in Form ihrer Salze oder Komplexe vorliegen.

4. Lösung gemäß Anspruch 3, dadurch gekennzeichnet, daß die Salze als Nitrate, Sulfate, Halogenide oder Carbonsäuresalze und die Komplexe als Cyanokomplexe vorliegen.

5. Lösung gemäß Anspruch 1, dadurch gekennzeichnet, daß diese als Ätzmittel ein Oxydationsmittel enthält.

6. Lösung gemäß Anspruch 5, dadurch gekennzeichnet, daß ein Oxydationsmittel auf Basis von sechswertigen Chromionen oder Permanganationen, enthalten ist.

6

7. Lösung gemäß Anspruch 6, dadurch gekennzeichnet, daß diese eine alkalische Permanganatlösung darstellt.

8. Lösung gemäß Anspruch 1, dadurch gekennzeichnet, daß diese zusätzlich eine oder mehrere Verbindungen der Elemente Zink, Zinn, Titan, Aluminium, Zirkonium, Mangan, Wolfram und/oder Molybdän enthält.

9. Lösung gemäß Anspruch 1, dadurch gekennzeichnet, daß der Aktivator in Konzentrationen von 0,01 g/Liter bis zur Sättigungsgrenze, vorzugsweise 1,0 g/Liter und das Ätzmittel in Konzentration von 5 g/Liter bis zur Sättigungsgrenze enthalten ist.

10. Lösung gemäß Anspruch 1, dadurch gekennzeichnet, daß es eine wässrige Lösung ist.

11. Verfahren zum gleichzeitigen Ätzen und Aktivieren einer isolierenden Oberfläche zum Zwecke der nachfolgenden chemischen und gegebenenfalls galvanischen Abscheidung von Metallüberzügen, dadurch gekennzeichnet, daß Lösungen gemäß den Ansprüchen 1 bis 9 verwendet werden.

12. Verfahren gemäß Anspruch 11, dadurch gekennzeichnet, daß die Lösung bei Temperaturen von Raumtemperatur bis 98° C verwendet wird.

13. Verfahren zur Metallisierung isolierender Oberflächen, dadurch gekennzeichnet, daß die für die autokatalytische Metallabscheidung erforderliche Aktivierung der isolierenden Oberfläche zusammen mit einer Ätzbehandlung für die Substratoberfläche in einem Behandlungsschritt erfolgt oder die für die autokatalytische Metallabscheidung erforderliche Aktivierung der isolierenden Oberfläche zusammen mit der einer Ätzbehandlung für die Substratoberfläche nachfolgenden Behandlungslösung zur Entfernung des Ätzmittels und von Ätzmittelrückständen in einem Behandlungsschritt erfolgt.

14. Verfahren gemäß Anspruch 13, dadurch gekennzeichnet, daß als Ätzmittel alkalische Permanganatlösungen eingesetzt werden.

15. Verfahren nach Anspruch 14, dadurch gekennzeichnet, daß der während des Ätzvorganges entstehende Mangandioxidbelag Verbindungen der Aktivierungsmittel enthält.

16. Verfahren nach Anspruch 15, dadurch gekennzeichnet, daß der Mangandioxidbelag auf der Oberfläche verbleibt.

17. Verfahren nach Anspruch 16, dadurch gekennzeichnet, daß die in dem Mangandioxidbelag enthaltenen Aktivierungsmittel in einem nachfolgenden Behandlungsschritt zu den Elementen reduziert werden.

18. Verfahren gemäß Anspruch 13, dadurch gekennzeichnet, daß die auf der Substratoberfläche fixierten Verbindungen des Aktivierungsmittels in einem nachfolgenden Behandlungsschritt reduziert werden.

19. Verfahren gemäß Anspruch 13, dadurch gekennzeichnet, daß die Metallisierung in einem autokatalytischen Kupferbad oder Nickelbad vorgenommen wird.

20. Verfahren gemäß Ansprüchen 11 bis 19 zur Herstellung elektrischer Verbindungselemente.

| EINSCHLÄGIGE DOKUMENTE | | | EP 89107191.2 |
|---|---|---|---|
| **Kategorie** | Kennzeichnung des Dokuments mit Angabe, soweit erforderlich, der maßgeblichen Teile | **Betrifft Anspruch** | **KLASSIFIKATION DER ANMELDUNG (Int. Cl.4)** |
| A | US - A - 4 629 636<br>(CONSTANTINE I.COURDUVELIS)<br> * Ansprüche 1,3,4; Spalte 6,<br> Zeile 38 - Spalte 7, Zeile21<br>-- | 1,3,5-<br>7 | C 23 C 18/18<br>C 25 D 5/56 |
| A | DE - A1 - 3 511 105<br>(DORNIER GMBH)<br> * Anspruch 1; Seite 6, Zeile<br> 9 - Seite 7, Zeile 9 *<br>-- | 1,11,<br>13,19 | |
| A | EP - A2/A3 - 0 261 424<br>(SHIPLEY COMPANY INC.)<br> * Ansprüche 1,3,7,8 *<br>---- | 1,11,<br>13,19,<br>20 | |
| | | | **RECHERCHIERTE SACHGEBIETE (Int. Cl.4)**<br><br>C 23 C 18/00<br>C 25 D 5/00 |

Der vorliegende Recherchenbericht wurde für alle Patentansprüche erstellt.

| Recherchenort | Abschlußdatum der Recherche | Prüfer |
|---|---|---|
| WIEN | 27-07-1989 | DUNGLER |